# FASCICULE DE BREVET EUROPEEN

(11) **EP 2 721 738 B1**
(45) Date de publication et mention de la délivrance du brevet: **01.04.2015**
(21) Numéro de dépôt: 12750407.4
(22) Date de dépôt: 08.06.2012
(51) Int. Cl.: H03K 17/96, G06F 3/044, G06F 3/041

(54) **DISPOSITIF ET PROCEDE POUR GENERER UNE ALIMENTATION ELECTRIQUE DANS UN SYSTEME ELECTRONIQUE AVEC UN POTENTIEL DE REFERENCE VARIABLE**
VORRICHTUNG UND VERFAHREN ZUR ERZEUGUNG EINER STROMVERSORGUNG IN EINEM ELEKTRONISCHEN SYSTEM MIT VARIABLEM BEZUGSPOTENTIAL
DEVICE AND METHOD FOR GENERATING A POWER SUPPLY IN AN ELECTRONIC SYSTEM WITH VARIABLE REFERENCE POTENTIAL

(30) Priorité: 16.06.2011 FR 1155285
(43) Date de publication de la demande: 23.04.2014
(73) Titulaire: Nanotec Solution, 30900 Nîmes (FR)
(72) Inventeur: BLONDIN, Christophe, F-30900 Nîmes (FR); NEEL, Christian, F-30900 Nîmes (FR); ROZIERE, Didier, F-30900 Nîmes (FR)
(74) Mandataire: Pontet Allano & Associes
(86) Numéro de dépôt international: PCT/FR2012/051288
(87) Numéro de publication internationale: WO 2012/172239

(56) Documents cités:
- US-A1- 2010 097 346
- US-A1- 2010 139 991
- US-A1- 2011 001 491
- US-A1- 2011 061 949
- US-B1- 6 587 358

## Description

### Domaine technique

La présente invention concerne un dispositif pour générer une alimentation électrique dans un système électronique avec un potentiel de référence variable.

Le domaine de l'invention est plus particulièrement mais de manière non limitative celui des dispositifs d'alimentation électronique.

### Etat de la technique antérieure

De manière générale, les systèmes électroniques sont référencés par rapport à un potentiel de masse, qui peut être par exemple une référence en tension par rapport à laquelle sont fixées les tensions d'alimentation. Cette masse peut être ou non reliée à la terre.

Dans certains cas, il est nécessaire que des parties ou des sous-systèmes électroniques soient référencés à des potentiels différents du potentiel de masse du système global, et flottants ou variables par rapport à ce dernier. On rencontre ce cas de figure par exemple dans des systèmes de mesure, pour s'affranchir de perturbations électriques sources de bruit.

Parfois, la partie flottante n'est pas totalement séparée du reste du système par une isolation galvanique, mais elle est flottante ou variable uniquement dans une gamme de fréquences, ou autour d'une fréquence de travail.

Des dispositions particulières sont nécessaires pour pouvoir alimenter électriquement un sous-système flottant et transmettre des signaux analogiques et/ou numériques entre ce système flottant et la partie référencée au potentiel de masse.

On rencontre ce cas de figure par exemple dans le document FR 2 756 048 de Rozière qui divulgue un système de mesure capacitif. Le circuit de détection comprend une partie flottante dans une gamme de fréquences, dont le potentiel de référence oscille par rapport à la masse du système global à une fréquence d'oscillation.

Les tensions d'alimentation sont transmises à la partie flottante par l'intermédiaire de bobines d'inductance ou selfs de choc placées en série sur les lignes de telle sorte à présenter une impédance élevée à la fréquence d'oscillation du potentiel de référence flottant.

Le même principe peut être utilisé pour transmettre des signaux numériques ou analogiques.

On peut également transmettre ces signaux numériques ou analogiques entre les parties flottantes et non flottantes par d'autres moyens connus tels que les amplificateurs différentiels, les optocoupleurs, ou des moyens de transmission par ondes radiofréquences.

Les fonctions électroniques doivent souvent être réalisées sous la forme de circuits électroniques intégrés avec un encombrement et une consommation électrique minimale. C'est particulièrement vrai pour les systèmes de mesure capacitifs qui sont de plus en plus utilisés pour réaliser des interfaces tactiles de systèmes portables (téléphones, ordinateurs, ...).

Dans ce contexte, les moyens connus pour transmettre des signaux et les alimentations entre les parties flottantes et non flottantes présentent des inconvénients gênants, tels qu'un encombrement et une consommation élevée.

Ces inconvénients sont particulièrement importants en ce qui concerne l'alimentation électrique des parties flottantes ou soumises à des potentiels de référence variables. En effet, les sources d'alimentation sont plus facilement disponibles du côté des parties non flottantes et il est nécessaire de transférer entre les systèmes à des potentiels de référence différents des signaux électriques sensiblement continus et de puissance suffisante. Cela implique l'utilisation d'inductances (selfs de choc) ou de convertisseurs DC/DC particulièrement pénalisants pour la réalisation de circuits intégrés.

Le but de la présente invention est de proposer un dispositif et un procédé pour générer une alimentation électrique avec un potentiel de référence variable à partir d'une source de puissance à un autre potentiel de référence, sans nécessiter l'utilisation de composants d'isolation électrique pénalisants.

### Exposé de l'invention

Cet objectif est atteint avec un dispositif pour générer une tension d'alimentation référencée à un premier potentiel de référence selon la revendication 1.

Bien entendu, le terme « relié » doit être interprété dans le sens où des composants reliés entre eux peuvent être reliés directement, au travers d'une liaison électrique directe, ou reliés par l'intermédiaire de composants électriques ou électroniques additionnels.

Suivant des modes de réalisation, le dispositif selon l'invention peut comprendre en outre :
- une source d'excitation référencée au second potentiel de référence ;
- une source d'excitation comprenant un buffer référencé au second potentiel de référence, relié en sortie au premier potentiel de référence, et piloté en entrée par un oscillateur référencé audit premier potentiel de référence ;
- des moyens de redressement et de filtrage reliés en entrée aux bornes de la source d'excitation, ou le cas échéant au buffer de la source d'excitation ;
- des moyens de redressement et de filtrage reliés en entrée au second potentiel de référence, de telle sorte à générer en une sortie une tension d'alimentation référencée au premier potentiel de référence par redressement de la tension aux bornes d'une source d'excitation référencée au second potentiel de référence.

Le dispositif selon l'invention peut comprendre en outre une source de tension d'alimentation alternative comprenant au moins une seconde source de tension alternative reliée au second potentiel de référence, et des moyens de redressement et de filtrage reliés en entrée à ladite seconde source de tension alternative.

Il peut alors comprendre en outre une source d'excitation référencée au premier potentiel de référence.

Ainsi, suivant des modes de réalisation, la source d'excitation peut être référencée au premier potentiel de référence. Dans ce cas, la source de tension d'alimentation alternative selon l'invention comprend au moins une seconde source de tension alternative référencée au second potentiel de référence, qui fournit l'essentiel de la puissance. La source d'excitation est alors utilisée comme trajet de retour pour le courant de cette seconde source de tension alternative.

La source d'excitation peut également être référencée au second potentiel de référence. Dans ce cas, elle peut être utilisée comme seule source de tension pour la source de tension d'alimentation alternative selon l'invention. Elle peut également être utilisée conjointement avec une seconde source de tension alternative reliée au second potentiel de référence, dans une configuration active dans laquelle sa tension contribue à la source de tension d'alimentation alternative, ou dans une configuration passive (par exemple si les fréquences des sources sont très différentes) auquel cas elle est utilisée comme trajet de retour pour le courant de cette seconde source de tension alternative.

Enfin, la source d'excitation peut comprendre un buffer référencé au second potentiel de référence, relié en sortie au premier potentiel de référence, et piloté en entrée par un oscillateur référencé au premier potentiel de référence. Ce buffer peut être par exemple réalisé au moyen d'amplificateurs opérationnels. Le buffer fournit la puissance nécessaire à l'excitation du premier potentiel de référence relativement au second, conformément au signal fourni par l'oscillateur. Il se comporte de fait comme une source d'excitation référencée au second potentiel de référence.

Dans tous les cas la source d'excitation est englobée (ou comprise ou incluse) dans la source de tension d'alimentation alternative selon l'invention car sa présence est un élément nécessaire à son bon fonctionnement.

En effet, ces configurations sont possibles car la source d'excitation se comporte sensiblement comme un générateur de tension parfait, appelé également générateur de Thévenin. Il permet d'imposer une différence de tension alternative entre les premiers et seconds potentiels de référence, tout en présentant une impédance très faible pour le courant d'alimentation. Ce résultat ne pourrait pas être obtenu sans la présence de la source d'excitation.

Lorsque la source d'excitation comprend un buffer référencé au second potentiel de référence relié en sortie au premier potentiel de référence, c'est ce buffer qui se comporte en sortie comme un générateur de Thévenin placé entre le premier potentiel de référence et, via l'alimentation du buffer, le second potentiel de référence.

Suivant des modes de réalisation, les moyens de redressement et de filtrage peuvent comprendre :
- des moyens de commutation ;
- au moins une diode insérée entre la source de tension d'alimentation alternative et la sortie de la tension d'alimentation ;
- une diode à faible seuil;
- une diode de type Schottky, une diode au germanium, ... ;
- un condensateur de filtrage relié d'une part au premier potentiel de référence et d'autre part à la sortie de la tension d'alimentation.

Le dispositif selon l'invention peut être réalisé selon des technologies d'électronique intégrée.

Suivant un autre aspect, il est proposé un système électronique de mesure capacitive comprenant un premier sous-système référencé électriquement à un potentiel de garde, un second sous-système référencé électriquement à un potentiel de masse, et une source d'excitation ayant des bornes reliées respectivement auxdits potentiels de garde et de masse de telle sorte à imposer entre ces potentiels de masse et de garde une différence de tension alternative, lequel système électronique de mesure capacitive comprenant en outre un dispositif selon l'invention pour générer une tension d'alimentation référencée audit potentiel de garde.

Le système électronique de mesure capacitive peut comprendre en outre un amplificateur de charge référencé au potentiel de garde et alimenté par un dispositif selon l'invention pour générer une tension d'alimentation référencée audit potentiel de garde.

Suivant encore un autre aspect, il est proposé un procédé pour générer une tension d'alimentation référencée à un premier potentiel de référence dans un système électronique comprenant une source d'excitation reliée auxdits premier et second potentiels de référence de telle sorte à imposer entre ces potentiels de référence une différence de tension alternative,

Lequel procédé comprenant en outre des étapes :
- de génération d'une tension d'alimentation alternative au moyen d'une source de tension d'alimentation alternative référencée audit second potentiel de référence, reliée audit premier potentiel de référence, et englobant ladite source d'excitation, et
- de redressement d'une tension aux bornes de ladite source de tension d'alimentation alternative, avec des moyens de redressement et de filtrage reliés en entrée respectivement audit premier potentiel de référence et à ladite source de tension d'alimentation alternative, de telle sorte à générer en une sortie desdits moyens de redressement et de filtrage une tension d'alimentation référencée audit premier potentiel de référence.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre un mode de réalisation de dispositif de génération de tension d'alimentation selon l'invention entre des systèmes électroniques dont les potentiels de référence sont reliés par un signal périodique comprenant un premier mode de réalisation de moyens de redressement et de filtrage et une source de tension d'alimentation alternative comprenant une source d'excitation et une seconde source de tension alternative,
- la figure 2 illustre un mode de réalisation de dispositif de génération de tension d'alimentation selon l'invention comprenant un premier mode de réalisation de moyens de redressement et de filtrage et une source de tension d'alimentation alternative comprenant une source d'excitation,
- la figure 3 illustre un mode de réalisation de dispositif de génération de tension d'alimentation selon l'invention comprenant un second mode de réalisation de moyens de redressement et de filtrage,
- la figure 4 illustre un mode de réalisation de dispositif de génération de tension d'alimentation selon l'invention comprenant un troisième mode de réalisation de moyens de redressement et de filtrage,
- la figure 5 illustre un mode de réalisation d'un système électronique de mesure capacitive mettant en oeuvre un dispositif de génération de tension d'alimentation selon l'invention, et
- la figure 6 illustre un exemple de mode de réalisation d'un système électronique de mesure capacitive de l'art antérieur.

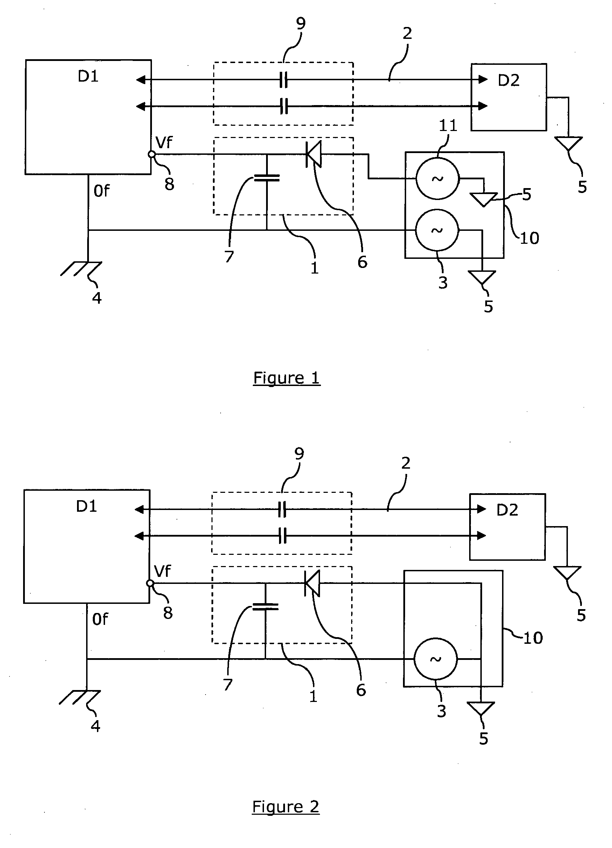

En référence à la figure 1, l'objet de la présente invention est de permettre la génération d'une alimentation électrique **Vf** avec un potentiel de référence variable **Of** à partir d'une source de puissance à un autre potentiel de référence.

L'invention permet notamment d'éviter l'utilisation de composants d'isolation électrique pénalisants en termes d'intégration dans des circuits électroniques intégrés tels que des ASICs (en anglais : « Application Specific Integrated Circuit »).

Elle trouve son application dans des applications électroniques nécessitant l'interconnexion de systèmes électroniques D1, D2 dont les potentiels de référence 4, 5 sont reliés par un signal alternatif périodique généré par une source d'excitation 3. Ce signal alternatif peut être de toute forme, par exemple sinusoïdal, carré, ou triangulaire.

Cette situation se retrouve, par exemple, dans des systèmes de mesure électroniques.

Suivant une configuration fréquente mais non limitative, le système électronique comprend :
- un système D2 référencé électriquement à la masse ou à la terre 5, qui comprend les moyens d'alimentation électrique de l'ensemble, ou est relié à un réseau d'alimentation électrique ;
- un autre système électronique D1 référencé électriquement à un potentiel de référence variable 4, qui comprend par exemple des moyens électroniques de mesure ou de détection à grande sensibilité et/ou à faible bruit ;
- une source d'excitation 3 de tension alternative qui relie (directement ou indirectement) la masse 5 et la référence variable 4, de telle sorte à faire osciller la tension de référence variable 4 par rapport à la masse 5.

Les systèmes électroniques D1 et D2 sont reliés par des liaisons électriques 2 qui permettent de faire transiter par exemple des signaux numériques ou analogiques. Ces liaisons électriques 2 sont pourvues de moyens de découplage 9 pour assurer une isolation entre les potentiels de référence 4 et 5, au moins dans une gamme de fréquences. Ces moyens de découplage 9 peuvent comprendre par exemple des inductances insérées en série sur les lignes ou des amplificateurs opérationnels différentiels. Ils peuvent également comprendre des capacités, ce qui constitue une solution avantageuse en termes d'intégration dans un contexte de réalisation de circuits sous la forme de circuits intégrés.

Il est connu de générer des alimentations électriques pour le système électronique D1 au potentiel de référence variable 4 en transférant des alimentations électriques du système au potentiel de masse D2, par exemple au travers de liaisons électriques 2 pourvues de moyens de découplage 9. Dans ce cas, ces moyens de découplage 9 doivent pouvoir laisser passer de la puissance à basse fréquence, ce qui implique l'emploi de composants tels que des inductances ou des transformateurs, pénalisants en termes d'intégration dans des circuits intégrés.

Il est également connu d'utiliser des convertisseurs DC/DC, mais qui sont également pénalisants en termes d'encombrement dans des circuits intégrés.

Dans le but de générer le potentiel variable 4, la source d'excitation 3 peut être indifféremment référencée à ce potentiel de référence variable 4 ou au potentiel de masse 5. Elle est alors alimentée, respectivement, par une alimentation référencée au potentiel de référence variable 4 ou au potentiel de masse 5.

Toutefois, les sources d'alimentation électriques étant en général plus aisément disponibles dans l'un des systèmes D1 ou D2, il est préférable de mettre en oeuvre une source d'excitation 3 référencée au potentiel de référence correspondant 4 ou 5. Ainsi, il est souvent préférable que la source d'excitation 3 soit référencée au potentiel de masse 5. Elle peut alors être alimentée par une alimentation référencée à ce même potentiel de masse 5, qui est plus aisément disponible et apte à fournir une puissance électrique adéquate.

Suivant un aspect avantageux de l'invention, la source d'excitation 3 est utilisée pour la réalisation d'une source de tension d'alimentation alternative 10, apte à générer une ou plusieurs tension(s) d'alimentation **Vf** référencée(s) au potentiel variable 4.

Selon le mode de réalisation présenté à la figure 1, la source de tension d'alimentation alternative 10 comprend donc la source d'excitation 3 et au moins une seconde source de tension alternative 11. La seconde source de tension alternative 11 est reliée au potentiel de masse 5. Elle est donc reliée, par l'intermédiaire de la masse 5 ou directement, à la source d'excitation 3. Le dispositif selon l'invention comprend également des moyens de redressement et de filtrage 1 qui sont reliés en entrée aux bornes de la source d'alimentation alternative 10, et donc insérés autour de la source d'excitation 3, entre les systèmes électroniques D1 et D2.

Du point de vue des moyens de redressement et de filtrage, la source d'alimentation alternative 10 comprend donc, en série, la source d'excitation 3 et la seconde source de tension alternative 11.

La source d'excitation 3 a pour fonction de permettre un retour du circuit d'alimentation par une liaison entre le potentiel de référence variable 4 et le potentiel de masse 5, sans court-circuiter ces potentiels de références aux fréquences du signal d'excitation de la source d'excitation 3. Cet effet est obtenu comme expliqué précédemment grâce au fonctionnement en générateur de Thévenin de la source d'excitation 3, qui impose le signal d'excitation entre les potentiels de référence variable 4 et de masse 5, tout en ayant une impédance faible.

Suivant les configurations, la source d'excitation 3 peut contribuer de manière plus ou moins importante à la génération de la tension de la source d'alimentation alternative 10. A la base, sa contribution est celle d'une source de tension placée en série avec la seconde source de tension alternative 11. Par exemple :
- si les signaux de la source d'excitation 3 et de la seconde source de tension alternative 11 sont de fréquences proches, leur contributions à la tension de la source d'alimentation alternative 10 se combinent ;
- si les signaux de la source d'excitation 3 et de la seconde source de tension alternative 11 sont de fréquences très différentes, les signaux de la source d'excitation 3 peuvent être rejetés par des composants de filtrage (capacités par exemple) dans les moyens de redressement et de filtrage. Cette configuration permet de générer des tensions d'alimentations **Vf** référencées au potentiel de référence variable 4 indépendantes des caractéristiques des signaux de la source d'excitation 3, tout en exploitant les propriétés de la liaison qu'il confère entre les potentiels de masse 5 et de référence variable 4. Ainsi, il est possible par exemple de moduler l'amplitude de la source d'excitation 3 sans modifier la tension d'alimentation **Vf** qui ne dépend que de la seconde source de tension alternative 11.

Les moyens de redressement et de filtrage 1 ont pour fonction :
- de redresser le signal de la source d'alimentation alternative 10, c'est-à-dire de générer une tension d'alimentation **Vf** avec une valeur moyenne non-nulle à partir du signal de la source d'alimentation alternative 10 qui peut être à valeur moyenne nulle ou quelconque ;
- de lisser le signal redressé pour réduire l'amplitude des ondulations de tension.

Suivant un exemple de mode de réalisation présenté à la figure 1, ils comprennent :
- un élément redresseur de tension 6, relié à une borne de la source d'alimentation alternative 10. La sortie de cet élément redresseur fournit la tension d'alimentation **Vf,** qui est référencée au potentiel variable 4 et qui est donc utilisable pour le système D1. Suivant le mode de réalisation de la figure 1, cet élément est une diode 6, par exemple à faible seuil de type Schottky. L'orientation de cette diode 6 est en général indifférente, en particulier si la source d'alimentation alternative 10 délivre un signal symétrique. En effet, suivant son sens, elle bloque les alternances positives ou négatives, respectivement, du signal de la source d'alimentation alternative 10, et conditionne ainsi le signe de l'alimentation **Vf ;**
- un élément de filtrage 7 qui peut se limiter à un condensateur 7 relié, respectivement, à la sortie 8 de la diode 6 à l'opposé de la masse 5, et à la sortie de la source d'alimentation alternative 10 reliée au potentiel de référence variable 4. Le condensateur 7 effectue un lissage du signal redressé issu de la diode 6.

En référence à la figure 2, la source d'alimentation alternative 10 peut être constituée par la source d'excitation 3, référencée au potentiel de masse 5. Les moyens de redressement et de filtrage 1 (identiques dans l'exemple de la figure 1 à ceux de la figure 2) sont alors reliés aux bornes de la source d'excitation 3.

On constitue ainsi un dispositif 1 redresseur de la tension de la source d'excitation 3 qui est relié aux bornes de cette dernière suivant une disposition inversée par rapport aux schémas classiques de l'art antérieur (puisque la diode 6 est de fait reliée à la sortie à la masse 5 de la source d'excitation 3). Mais la sortie active de la source d'excitation 3 étant également reliée au potentiel variable 4, il s'ensuit que l'on génère ainsi avec un minimum de composants facilement intégrables une tension d'alimentation redressée **Vf** référencée au potentiel variable 4 et disponible pour le système au potentiel de référence variable D1.

Des moyens de redressement et de filtrage 1 élévateurs ou abaisseurs de tensions, permettant d'ajuster la tension d'alimentation aux contraintes techniques des circuits tout en minimisant les pertes, peuvent également être mis en oeuvre dans le cadre de l'invention.

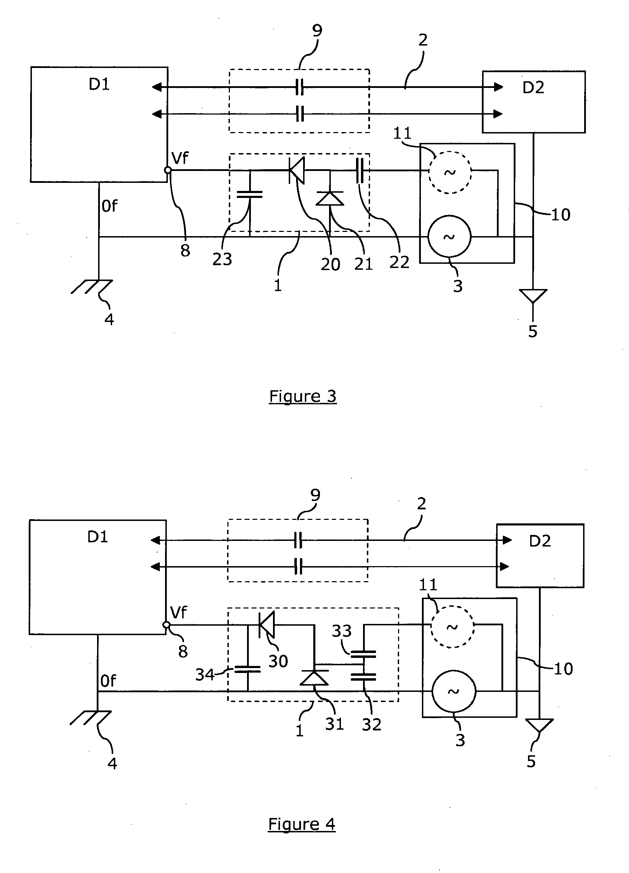

La figure 3 présente un exemple de mode de réalisation dans lequel les moyens de redressement et de filtrage 1 comprennent un dispositif élévateur de tension connu par exemple sous le nom de redresseur doubleur de tension de Schenkel.

Ce mode de réalisation peut être mis en oeuvre avec différents modes de réalisation de la source d'alimentation alternative 10, laquelle pouvant comprendre la source d'excitation 3 et éventuellement une ou plusieurs source(s) de tension alternative(s) 11.

Le dispositif élévateur de tension comprend les diodes 20, 21 et la capacité 22, agencées comme présenté à la figure 2. Il permet, à partir d'une source de tension alternative symétrique ou du moins bipolaire 11, de délivrer en sortie 8 une tension d'alimentation **Vf** référencée au potentiel variable 4 dont l'amplitude est de l'ordre de l'amplitude crête à crête du signal de la source 11. Les diodes 20, 21 sont de préférence des diodes Schottky à faible seuil.

Les moyens de redressement et de filtrage 1 comprennent également un élément de filtrage 23 qui peut se limiter à un condensateur 23 relié, respectivement, à la sortie 8 de la diode 20, et à la sortie de la source d'excitation 3 reliée au potentiel de référence variable 4. Le condensateur 7 effectue un lissage du signal redressé issu du dispositif élévateur de tension.

La figure 4 présente un exemple de mode de réalisation dans lequel les moyens de redressement et de filtrage 1 comprennent un dispositif diviseur de tension à haut rendement.

Ce mode de réalisation peut être mis en oeuvre avec différents modes de réalisation de la source d'alimentation alternative 10, laquelle pouvant comprendre la source d'excitation 3 et éventuellement une ou plusieurs source(s) de tension alternative(s) 11.

Le dispositif diviseur de tension comprend les diodes 30, 31 et les capacités 32, 33, agencées comme présenté à la figure 3. Il permet, à partir d'une source de tension alternative unipolaire 10 (c'est-à-dire oscillant entre une valeur maximale ou minimale de tension et le potentiel de référence 5), de délivrer en sortie 8 une tension d'alimentation **Vf** référencée au potentiel variable 4 dont l'amplitude est par exemple de l'ordre de la moitié de l'amplitude crête à crête du signal de la source 10 si les capacités 32, 33 sont de même valeur. Les diodes 30, 31 sont de préférence des diodes Schottky à faible seuil.

Les moyens de redressement et de filtrage 1 comprennent également un élément de filtrage 34 qui peut se limiter à un condensateur 34 relié, respectivement, à la sortie 8 de la diode 30, et à la sortie de la source d'excitation 3 reliée au potentiel de référence variable 4. Le condensateur 34 effectue un lissage du signal redressé issu du dispositif élévateur de tension.

Suivant des variantes,
- une source d'alimentation alternative 10 peut comprendre une pluralité de sources de tension alternative 11 ;
- plusieurs alimentations **Vf** peuvent être réalisées à partir d'une même source d'excitation 3, et/ou d'une même source d'alimentation alternative 10 ;
- tous moyens de redressement et de filtrage 1 permettant de générer une ou plusieurs tension(s) d'alimentation **Vf** référencée(s) au potentiel variable 4 à partir d'une source d'alimentation alternative 10 peuvent être mis en oeuvre dans le cadre de l'invention. Ils peuvent comprendre, de manière non limitative, des systèmes à transfert de charge, à pompe de charge, élévateur, atténuateur de tension, commutateurs, réalisée par association de capacités et de diodes ou par tout autres moyens ;
- les moyens de redressement et de filtrage 1 peuvent mettre en oeuvre tout type de moyens de commutation aptes à permettre un redressement du signal de la source d'alimentation alternative 10. Ils peuvent comprendre par exemple des commutateurs passifs tels que des diodes ne laissant passer que des signaux avec une polarité déterminée, des diodes Schottky pour réduire les pertes, ou des commutateurs analogiques actifs, commandés, par exemple à base de transistors ;
- la fonction de lissage peut être effectuée par des éléments équivalents, tels que des capacités parasites, et dans la mesure de ce qui est nécessaire pour les besoins de l'utilisation de la tension d'alimentation **Vf.**
- les signaux de la ou des source(s) de tension alternative 11 et/ou de la source d'excitation 3 peuvent être sinusoïdal, carré ou de toute autre forme ;
- la ou les source(s) de tension alternative 11 et/ou la source d'excitation 3 peuvent comprendre un oscillateur bipolaire, symétrique, délivrant un signal compris entre une valeur positive et une valeur négative, ou unipolaire, asymétrique, délivrant un signal compris entre une valeur maximale ou minimale et le potentiel de référence 5;
- la ou les source(s) de tension alternative 11 et/ou la source d'excitation 3 peuvent être de type analogique ou numérique, par exemple à synthèse numérique directe (DDS) ;

Des dispositifs selon l'invention peuvent être avantageusement mis en oeuvre dans une grande variété de systèmes électroniques qui nécessitent des masses 4, 5 à des potentiels différents mais pas nécessairement isolés.

Le dispositif selon l'invention est particulièrement bien adapté pour réaliser l'alimentation de la partie flottante (ou à un potentiel de référence variable) d'un système de mesure capacitif en pont flottant tel que décrit par exemple dans le document FR 2 756 048 de Rozière. En effet, dans cette application, le circuit de détection comprend une partie dite flottante dont le potentiel de référence, appelé potentiel de garde, oscille par rapport à la masse du système global, ou à la terre. La différence de potentiel alternative entre le potentiel de garde et la masse est générée par une source d'excitation. Dans les modes de réalisation décrits dans FR 2 756 048, les alimentations de la partie référencée à la garde sont réalisées notamment au travers de convertisseurs DC/DC et/ou de bobines d'inductances, à partir des alimentations de la partie référencée à la masse. Comme expliqué précédemment, ces composants sont très pénalisants en termes d'intégration dans des circuits intégrés.

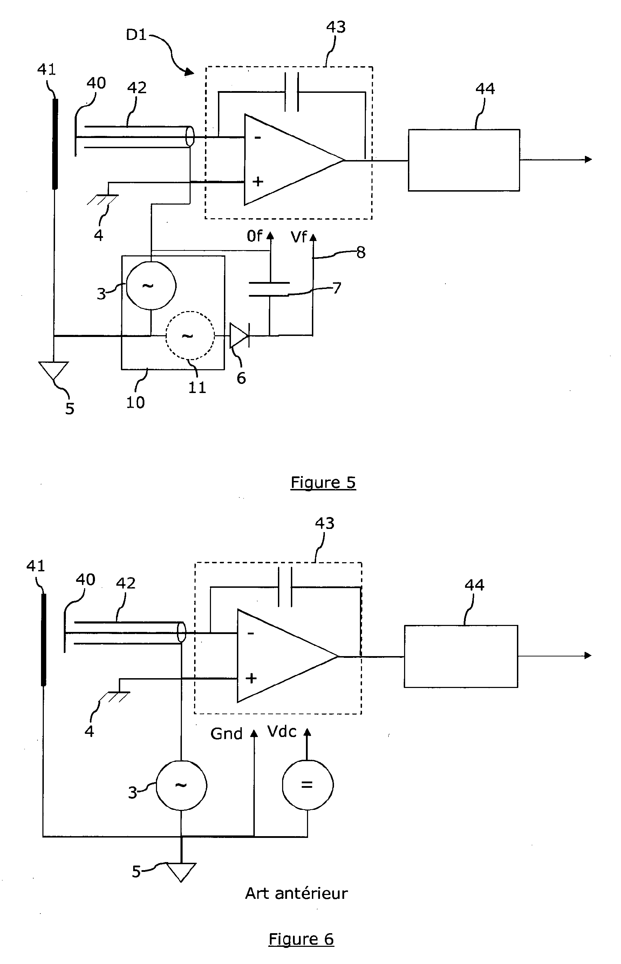

La figure 5 présente un exemple de configuration d'un système de mesure capacitif en pont flottant tel que décrit dans le document FR 2 756 048, en mode de mesure de capacité, auquel a été ajouté un dispositif d'alimentation selon l'invention. Le mode de réalisation présenté est, à titre d'exemple non limitatif, celui de la figure 1 ou de la figure 2. Pour homogénéiser les notations, on considère que le pont capacitif référencé à la garde correspond au système D1 de la figure 1 et la partie référencée à la masse ou à la terre correspond au système D2.

Ce système de mesure capacitif permet de mesurer une information de capacité entre au moins une électrode de mesure 40 et une cible 41 reliée à un potentiel différent du potentiel de garde 4, tel que par exemple le potentiel de masse 5.

Il comprend une partie flottante D1 référencée à un potentiel de garde 4 oscillant par rapport au potentiel de masse 5. Une source d'excitation 3 référencé au potentiel de masse 5 assure l'excitation du potentiel de garde 4. Une électrode de garde 42 protège l'électrode de mesure 40. Etant au même potentiel que cette dernière, elle évite l'apparition de capacités parasites. L'électrode de mesure 40 est reliée à un amplificateur de charge 43 qui permet d'en mesurer la capacité.

Suivant les applications, la partie flottante de l'électronique D1 peut comprendre d'autres étages de traitement du signal 44, afin par exemple de délivrer un signal représentatif d'une distance entre l'électrode de mesure 40 et la cible 41. Le système peut en outre comprendre plusieurs électrodes 40 de toutes géométries. Il peut également comprendre un scrutateur inséré entre les électrodes 40 et l'amplificateur de charge 43, et permettant de mesurer séquentiellement la capacité de ces électrodes 40.

Le système électronique flottant D1 et en particulier l'amplificateur de charges 43 sont alimentés par un dispositif selon l'invention, comprenant une source de tension d'alimentation alternative 10 basée sur la source d'excitation 3. Ce dispositif d'alimentation comprend une diode de redressement 6 et une capacité de filtrage 7, qui délivrent une tension d'alimentation **Vf** référencée au potentiel de garde 4.

Ce montage en pont flottant de la figure 5 ou tel que décrit dans FR 2 756 048 permet de s'affranchir de toutes les capacités parasites, mais cet effet est atteint uniquement si les composants du système électronique flottant D1 sont réellement alimentés en mode flottant, d'où l'importance de générer des alimentations de la partie flottante D1 de qualité. En effet, dans ce cas, l'électrode de mesure 41, l'électrode de garde 42 et la référence **Of** de l'alimentation de l'amplificateur de charge 43 sont toutes approximativement au même potentiel flottant alternatif, et pratiquement aucune capacité parasite ne peut apparaître entre ces éléments.

La figure 6 illustre un système de mesure capacitive à garde active connu de l'art antérieur qui comprend également une garde 4 excitée par une source d'excitation 3. Toutefois, dans ce cas l'amplificateur de charge est alimenté par une source de tension **Vdc** référencée à la masse 5. Ce montage a l'inconvénient de permettre l'apparition de capacités de fuite notamment entre les entrées de l'amplificateur de charge 43 et son alimentation **Gnd.** Et ce problème apparaît pour tous les composants alimentés de cette manière, tels que par exemple un scrutateur.

Un système de mesure capacitif en pont flottant tel que décrit à la figure 5 permet notamment de réaliser des interfaces tactiles ou sans contact pour des appareils tels que des téléphones portables (smartphones) des tablettes, des ordinateurs, des détecteurs de proximité, des dalles de commande ou des caméras capacitives 3D. Les électrodes 40 peuvent être des électrodes transparentes, par exemple en ITO (oxyde d'indium dopé à l'étain), déposées sur un écran d'affichage ou une dalle tactile. Elles sont alors utilisées pour détecter l'approche et/ou le contact d'un objet de commande 41 tel qu'un doigt.

Dans ce cas, l'intégration de l'électronique sous forme de circuits intégrés ou d'ASICs d'encombrement minimum est fondamentale et l'invention prend toute son importance.

L'énergie que peut fournir une source d'excitation 3 pour alimenter l'électronique D1 est souvent suffisante car les techniques actuelles permettent de réaliser des circuits intégrés très peu gourmands en énergie : il est possible de réaliser un circuit intégré où l'électronique flottante ne consomme que quelques mW. En outre, la minimisation de la consommation électrique est une contrainte importante pour des utilisations dans des appareils portables.

Afin de réaliser un circuit intégré performant sur le plan capacitif, avec des fuites capacitives réduites au minimum, il est préférable d'intégrer deux composants distincts dans le circuit intégré, dont l'un pour la partie flottante D1 et l'autre pour la partie non flottante D2. On peut également séparer les deux zones par un blindage au potentiel de référence de la partie flottante.

La liaison 2 entre la sortie de l'électronique flottante D1 et la partie non flottante D2 peut être réalisée avec des capacités de couplage 9 en utilisant une transmission numérique. Les signaux numériques sont de préférence de cadence élevée, à haute fréquence, afin d'utiliser des capacités de couplage 9 de faible valeur pour ne pas trop charger la source d'excitation 3. On peut aussi utiliser un amplificateur différentiel alimenté par une alimentation référencée à la masse 5 qui récupère les signaux de la sortie de l'électronique flottante D1, qu'ils soient analogique ou numériques.

L'invention peut également être mise en oeuvre dans des applications très variées, parmi lesquelles on peut citer notamment :
- tous types d'électronique capacitive à pont flottant, avec tous types de traitement de signal tels que, des filtres, des démodulations synchrones analogiques ou numériques, des convertisseurs analogiques/numériques (ADC), des dispositifs d'asservissement pour réaliser des ponts de mesure de capacité **C** ou d'inverse de la capacité 1/**C**, des commande de commutateurs pour scruter séquentiellement plusieurs électrodes, ... ;
- tous systèmes de mesure capacitifs ou basés sur un autre principe physique comprenant une partie à un potentiel flottant ou variable ;
- des applications où il est nécessaire de limiter des courants parasites alternatifs entre des systèmes et assures une protection électromagnétique (CEM) ;
- toutes applications nécessitant l'interconnexion de systèmes électroniques dont toutes les tensions de référence ou une partie des tensions de référence sont flottantes avec des différences de potentiels alternatives ;
- tous systèmes électroniques comprenant des parties référencées à des potentiels différents, excités l'un relativement à l'autre par une source d'excitation 3, ces potentiels de référence pouvant être tous flottants ou variables par rapport à une masse ou une terre, et la source d'excitation 3 pouvant être référencée à un potentiel relié à une masse ou une terre ou flottant par rapport à une masse ou une terre.

## Revendications

1. Dispositif pour générer une tension d'alimentation **(Vf)** référencée à un premier potentiel de référence (4), dans un système électronique comprenant une source d'excitation (3) reliée audit premier potentiel de référence (4) et à un second potentiel de référence (5) de telle sorte à imposer entre ces premiers et seconds potentiels de référence (4, 5) une différence de tension alternative,
**caractérisé en ce qu'**il comprend en outre :
- une source de tension d'alimentation alternative (10) référencée audit second potentiel de référence (5), reliée audit premier potentiel de référence (4), et englobant ladite source d'excitation (3), et
- des moyens de redressement et de filtrage (1), reliés en entrée respectivement audit premier potentiel de référence (4) et à ladite source de tension d'alimentation alternative (10), de telle sorte à générer en une sortie (8) une tension d'alimentation **(Vf)** référencée audit premier potentiel de référence (4) par redressement d'une tension aux bornes de la source de tension d'alimentation alternative (10).

2. Dispositif selon la revendication 1, **caractérisé en ce qu'**il comprend en outre une source d'excitation (3) comprenant un buffer référencé au second potentiel de référence (5), relié en sortie au premier potentiel de référence (4), et piloté en entrée par un oscillateur référencé audit premier potentiel de référence (4).

3. Dispositif selon l'une des revendications précédentes, **caractérisé en ce qu'**il comprend en outre des moyens de redressement et de filtrage (1) reliés en entrée aux bornes de la source d'excitation (3).

4. Dispositif selon l'une des revendications précédentes, **caractérisé en ce que** qu'il comprend en outre une source de tension d'alimentation alternative (10) comprenant au moins une seconde source de tension alternative (11) reliée au second potentiel de référence (5), et des moyens de redressement et de filtrage (1) reliés en entrée à ladite seconde source de tension alternative (11).

5. Dispositif selon l'une quelconque des revendications précédentes, **caractérisé en ce que** les moyens de redressement et de filtrage (1) comprennent des moyens de commutation (6, 20, 21, 30, 31).

6. Dispositif selon l'une quelconque des revendications précédentes, **caractérisé en ce que** les moyens de redressement et de filtrage (1) comprennent au moins une diode (6, 20, 30) insérée entre la source de tension d'alimentation alternative (10) et la sortie (8) de la tension d'alimentation **(Vf).**

7. Dispositif selon l'une quelconque des revendications précédentes, **caractérisé en ce que** les moyens de redressement et de filtrage (1) comprennent au moins une diode (6, 20, 21, 30, 31) à faible seuil.

8. Dispositif selon l'une quelconque des revendications précédentes, **caractérisé en ce que** les moyens de redressement et de filtrage (1) comprennent en outre un condensateur de filtrage (7) relié d'une part au premier potentiel de référence (4) et d'autre part à la sortie (8) de la tension d'alimentation (Vf).

9. Dispositif selon l'une quelconque des revendications précédentes, **caractérisé en ce qu'**il est réalisé selon des technologies d'électronique intégrée.

10. Système électronique de mesure capacitive comprenant un premier sous-système (D1) référencé électriquement à un potentiel de garde (4), un second sous-système (D2) référencé électriquement à un potentiel de masse (5), et une source d'excitation (3) ayant des bornes reliées respectivement auxdits potentiels de garde (4) et de masse (5) de telle sorte à imposer entre ces potentiels de masse (5) et de garde (4) une différence de tension alternative,
**caractérisé en ce qu'**il comprend en outre un dispositif pour générer une tension d'alimentation **(Vf)** référencée audit potentiel de garde (4) selon l'une quelconque des revendications précédentes.

11. Système électronique de mesure capacitive selon la revendication 12, **caractérisé en ce qu'**il comprend en outre un amplificateur de charge (43) référencé au potentiel de garde (4) et alimenté par un dispositif pour générer une tension d'alimentation **(Vf)** référencée audit potentiel de garde (4) selon l'une quelconque des revendications 1 à 9.

12. Procédé pour générer une tension d'alimentation **(Vf)** référencée à un premier potentiel de référence (4), dans un système électronique comprenant une source d'excitation (3) reliée audit premier potentiel de référence (4) et à un second potentiel de référence (5) de telle sorte à imposer entre ces premiers et seconds potentiels de référence (4, 5) une différence de tension alternative,
**caractérisé en ce qu'**il comprend en outre des étapes :
- de génération d'une tension d'alimentation alternative au moyen d'une source de tension d'alimentation alternative (10) référencée audit second potentiel de référence (5), reliée audit premier potentiel de référence (4), et englobant ladite source d'excitation (3), et
- de redressement d'une tension aux bornes de ladite source de tension d'alimentation alternative (10), avec des moyens de redressement et de filtrage (1) reliés en entrée respectivement audit premier potentiel de référence (4) et à ladite source de tension d'alimentation alternative (10), de telle sorte à générer en une sortie (8) desdits moyens de redressement et de filtrage (1) une tension d'alimentation **(Vf)** référencée audit premier potentiel de référence (4).

## Patentansprüche

1. Vorrichtung zur Erzeugung einer auf ein erstes Bezugspotential (4) bezogene Versorgungsspannung **(Vf)** in einem elektronischen System, das eine Erregungsquelle (3) enthält, welche mit dem genannten ersten Bezugspotential (4) und mit einem zweiten Bezugspotential (5) derart verbunden ist, dass zwischen diesen ersten und zweiten Bezugspotentialen (4, 5) einen Wechselspannungsunterschied erzwungen wird,
**dadurch gekennzeichnet, dass** sie außerdem umfasst:
- eine Quelle der Wechselversorgungsspannung (10), auf das genannte zweite Bezugspotential (5) bezogen, mit dem genannten ersten Bezugspotential (4) verbunden und die genannte erste Erregungsquelle (3) umfassend, und
- Gleichrichtungs- und Filtereinrichtungen (1), am Eingang jeweils mit dem ersten Bezugspotential (4) und mit der genannten Quelle der Wechselversorgungsspannung (10) derart verbunden, dass an einem Ausgang (8) eine Versorgungsspannung **(Vf)** erzeugt wird, die auf das genannte erste Bezugspotential (4) über Gleichrichten einer Spannung an den Polen der Wechselversorgungsspannungsquelle (10) bezogen ist.

2. Vorrichtung nach Anspruch 1, **dadurch gekennzeichnet, dass** sie außerdem eine Erregungsquelle (3) umfasst, einen Buffer umfassend, welcher auf das zweite Bezugspotential (5) bezogen, am Ausgang mit dem ersten Bezugspotential (4) verbunden und am Eingang von einem auf das genannte erste Bezugspotential (4) bezogenen Oszillator gesteuert ist.

3. Vorrichtung nach einem der vorhergehenden Ansprüche, **dadurch gekennzeichnet, dass** sie außerdem Gleichrichtungs- und Filtereinrichtungen (1) umfasst, die am Eingang mit den Polen der Erregungsquelle (3) verbunden sind.

4. Vorrichtung nach einem der vorhergehenden Ansprüche, **dadurch gekennzeichnet, dass** sie außerdem eine Quelle der Wechselversorgungsspannung (10) umfasst, die mindestens eine zweite Wechselspannungsquelle (11) umfasst, mit dem zweiten Bezugspotential (5) verbunden, sowie Gleichrichtungs- und Filtereinrichtungen (1), am Eingang mit der genannten zweiten Wechselspannungsquelle (11) verbunden.

5. Vorrichtung nach einem der vorhergehenden Ansprüche, **dadurch gekennzeichnet, dass** die Gleichrichtungs- und Filtereinrichtungen (1) Kommunikationsmittel (6, 20, 21, 30, 31) umfassen.

6. Vorrichtung nach einem der vorhergehenden Ansprüche, **dadurch gekennzeichnet, dass** die Gleichrichtungs- und Filtereinrichtungen (1) mindestens eine Diode (6, 20, 30) umfassen, die zwischen der Quelle der Wechselversorgungsspannung (10) und dem Ausgang (8) der Versorgungsspannung **(Vf)** eingebaut ist.

7. Vorrichtung nach einem der vorhergehenden Ansprüche, **dadurch gekennzeichnet, dass** die Gleichrichtungs- und Filtereinrichtungen (1) mindestens eine Diode (6, 20, 21, 30, 31) mit niedriger Schwellenspannung umfassen.

8. Vorrichtung nach einem der vorhergehenden Ansprüche, **dadurch gekennzeichnet, dass** die Gleichrichtungs- und Filtereinrichtungen (1) außerdem einen Filterkondensator (7) umfassen, der einerseits mit dem ersten Bezugspotential (4) und andererseits mit dem Ausgang (8) der Versorgungsspannung (Vf) verbunden ist.

9. Vorrichtung nach einem der vorhergehenden Ansprüche, **dadurch gekennzeichnet, dass** sie nach Verfahren der integrierten Elektronik ausgeführt ist.

10. Elektronisches System zur kapazitiven Messung, umfassend ein erstes, auf ein Schutzpotential (4) elektrisch bezogenes Subsystem (D1) und ein zweites, auf ein Massepotential (5) elektrisch bezogenes Subsystem (D2) sowie eine Erregungsquelle (3) mit Polen, die jeweils mit den genannten Schutz- (4) und Massepotentialen (5) derart verbunden sind, dass zwischen diesen Masse- (5) und Schutzpotentialen (4) ein Wechselspannungsunterschied erzwungen wird,
**dadurch gekennzeichnet, dass** sie außerdem eine Vorrichtung zur Erzeugung einer Versorgungsspannung **(Vf)** umfasst, die auf das genannte Schutzpotential (4) nach einem der vorhergehenden Ansprüche bezogen ist.

11. Elektronisches System zur kapazitiven Messung nach Anspruch 10, **dadurch gekennzeichnet, dass** es außerdem einen ladungsempfindlichen Verstärker (43) enthält, der auf das Schutzpotential (4) bezogen ist und durch eine Vorrichtung zur Erzeugung einer Versorgungsspannung **(Vf)** versorgt wird, die auf das genannte Schutzpotential (4) nach einem der vorhergehenden Ansprüche 1-9 bezogen ist.

12. Vorrichtung zur Erzeugung einer auf ein erstes Bezugspotential (4) bezogenen Versorgungsspannung **(Vf)** in einem elektronischen System, das eine Erregungsquelle (3) enthält, die mit dem genannten ersten Bezugspotential (4) und mit einem zweiten Bezugspotential (5) derart verbunden ist, dass zwischen diesen ersten und zweiten Bezugspotentialen (4, 5) ein Wechselspannungsunterschied erzwungen wird,
**dadurch gekennzeichnet, dass** sie außerdem folgende Schritte umfasst:
- Erzeugung einer Wechselversorgungsspannung mittels einer Wechselversorgungsspannungsquelle (10), die auf das genannte zweite Bezugspotential (5) bezogen, mit dem genannten zweiten Bezugspotential (4) verbunden ist und die genannte Erregungsquelle (3) umfasst, und
- Gleichrichten einer Spannung an den Polen der genannten Quelle der Wechselversorgungsspannung (10) mit Gleichrichtungs- und Filtereinrichtungen (1), die am Eingang jeweils mit dem ersten Bezugspotential (4) und mit der genannten Quelle der Wechselversorgungsspannung (10) derart verbunden sind, dass an einem Ausgang (8) der genannten Gleichrichtungs- und Filtereinrichtungen (1) eine auf das genannte, erste Bezugspotential (4) bezogene Versorgungsspannung **(Vf)** erzeugt wird.

## Claims

1. Device for generating a power supply voltage **(Vf)** referenced to a first reference potential (4), in an electronic system comprising an excitation source (3) connected to said first and second reference potentials (4, 5) so as to impose an AC voltage difference between these reference potentials (4, 5),
**characterized in that** it comprises moreover:
- a source supplying an AC voltage (10) referenced to said second reference potential (5), connected to said first reference potential (4), and encompassing said excitation source (3), and
- rectifying and filtering means (1) connected at the input thereof to said first reference potential (4) and to said AC voltage supply source (10) respectively, so as to generate, at an output (8), a supply voltage **(Vf)** referenced to said first reference potential (4) by rectification of a voltage at the terminals of the AC voltage supply source (10).

2. Device according to claim 1, **characterized in that** it comprises moreover an excitation source (3) comprising a buffer referenced to the second reference potential (5), connected at its output to the first reference potential (4), and controlled at its input by an oscillator referenced to said first reference potential (4).

3. Device according to one of the preceding claims, **characterized in that** it comprises moreover rectifying and filtering means (1) connected at their input to the terminals of the excitation source (3).

4. Device according to one of the preceding claims, **characterized in that** it comprises moreover an AC voltage supply source (10) comprising at least one second AC voltage supply source (11) connected to the second reference potential (5), and rectifying and filtering means (1) connected at the input to said second AC voltage supply source (11).

5. Device according to any one of the preceding claims, **characterized in that** the rectifying and filtering means (1) comprise switching means (6, 20, 21, 30, 31).

6. Device according to any one of the preceding claims, **characterized in that** the rectifying and filtering means (1) comprise at least one diode (6, 20, 30) inserted between the AC voltage supply source (10) and the output (8) of the supply voltage **(Vf).**

7. Device according to any one of the preceding claims, **characterized in that** the rectifying and filtering means (1) comprise at least one diode (6, 20, 21, 30, 31) having a low threshold.

8. Device according to any one of the preceding claims, **characterized in that** the rectifying and filtering means (1) comprise moreover a filtering capacitor (7) connected on the one hand to the first reference potential (4) and on the other hand to the output (8) of the supply voltage (Vf).

9. Device according to any one of the preceding claims, **characterized in that** it is produced using integrated electronics technologies.

10. Electronic capacitive measurement system comprising a first subsystem (D1) electrically referenced to a guard potential (4), a second subsystem (D2) electrically referenced to a ground potential (5), and an excitation source (3) having terminals respectively connected to said guard (4) and ground (5) potentials so as to impose an AC voltage difference between these ground (5) and guard (4) potentials,
**characterized in that** it comprises moreover a device for generating a supply voltage **(Vf)** referenced to said guard potential (4) according to any one of the preceding claims.

11. Electronic capacitive measurement system according to claim 10, **characterized in that** it comprises moreover a charge amplifier (43) referenced to the guard potential (4) and supplied by a device for generating a supply voltage **(Vf)** referenced to said guard potential (4) according to any one of claims 1 to 9.

12. Method for generating a supply voltage **(Vf)** referenced to a first reference potential (4) in an electronic system comprising an excitation source (3) connected to said first and second reference potentials (4, 5) so as to impose an AC voltage difference between these reference potentials (4, 5),
**characterized in that** it comprises moreover steps:
- of generation of an AC supply voltage by means of an AC voltage supply source (10) referenced to said second reference potential (5), connected to said first reference potential (4), and encompassing said excitation source (3), and
- of rectification of a voltage at the terminals of said AC voltage supply source (10), with rectifying and filtering means (1) connected at their input respectively to said first reference potential (4) and to said AC voltage supply source (10), so as to generate at an output (8) of said rectifying and filtering means (1) a supply voltage **(Vf)** referenced to said first reference potential (4).
